# EUROPEAN PATENT SPECIFICATION

(11) **EP 0 275 588 B1**
(45) Date of publication and mention of the grant of the patent: **10.11.1993**
(21) Application number: 87202505.1
(22) Date of filing: 14.12.1987
(51) Int. Cl.: H01L 23/28

(54) **Method of fabricating a semiconductor device with reduced packaging stress**
Verfahren zum Herstellen einer Halbleitervorrichtung mit vermindertem Verpackungsdruck
Procédé de fabrication d'un dispositif semi-conducteur avec une contrainte à l'emballage réduite

(30) Priority: 19.12.1986 US 944268
(43) Date of publication of application: 27.07.1988
(73) Proprietor: Philips Electronics N.V., 5621 BA Eindhoven (NL)
(72) Inventor: Cagan, Myron Ralph, NL-5656 AA Eindhoven (NL); Ridley, Douglas Frederick, NL-5656 AA Eindhoven (NL); Belton, Daniel James, NL-5656 AA Eindhoven (NL)
(74) Representative: Rensen, Jan Geert

(56) References cited:
- EP-A- 0 122 631
- DE-A- 3 327 960
- US-A- 3 978 578

## Description

The invention relates to a method of fabricating a semiconductor device in which an electrically insulting layer (14) lies on an electrical interconnection system (12) contacting a semiconductive body (10), openings (24) extends through the insulating layer down to bond pads (16) of the interconnection system (12), each pad is in contact with a bonding portion (36) of a different one of a set of electrical conductors (32, 34) that lead through the openings (24) away from the interconnection structure, and an electrically insulating coating (48) covers the body (10), the interconnection system (12), the insulating layer (14), and the bonding portions (36) such that a part (32) of each conductor (32, 34) protrudes through the coating (48), in which method a stress-relief layer (46), which lies above the interconnection system (12) but does not lie above areas of the bond pads (16) where the bonding portions (36) are made, is formed between the insulating layer (14) and the insulating coating (48). The stress-relief layer is utilized as a mechanism to reduce mechanical packaging stress. Due to such a stress-relief layer the semi-conductor device can withstand relatively high temperature fluctuations.

From the Japanese Patent Application Disclosure No. 61-102758 a method of the kind mentioned before is known whereby the stress-relief layer is formed by forming walls on the insulating layer at the periphery of the bonding pads. Then a resin which will form the stress-relief layer between the insulating layer and the insulating coating is flown over the surface of the semiconductor body. The walls thereby prevent inflow of the resin in the holes formed in the insulating layer. The resin is stopped by the walls and does not coat the bonding portion of the conductors.

It is very difficult to make a semiconductor device using the known method in practice. Besides that extra process steps are required to make the walls which have to stop the inflow of resin in the holes in the insulating layer.

The method according to the invention keeps away from these problems. Therefor the method according to the invention wherein the stress-relief layer is made by forming a patternable layer (42, 58) on the insulating layer (14) and exposing portions of the patternable layer to radiation that causes the so exposed portions to change their chemical structure; and developing the patternable layer to remove parts of the patternable layer down to the pads (16), is characterised in that the remainder of the patternable layer, which forms the stress-relief layer (46), consists substantially of a polymeric, electrically insulating material that has a glass transition temperature T_{G} below 150°C.

The present invention provides a method of realising a stress-relief layer located in selected regions inside a packaged semiconductor device and having a glass transition temperature below 150°C. The stress-relief layer generally lies above an interconnect system in the device but does not lie above bond pad areas where bonding connections are made to the interconnect system. By virtue of this arrangement, the layer substantially alleviates thermally induced mechanical stress that would otherwise be placed on electronic components in the device while simultaneously allowing the maximum stress on electrical conductors that protrude from the device to occur at bonding areas which can tolerate the stress. The result is a significant improvement in IC lifetime.

More particularly, the invention entails a semiconductor device in which an insulating layer lies on an interconnection system contacting a semiconductive body. Openings extend through the insulating layer down to bond pads of the interconnection system. Each pad is in contact with a bonding portion, typically a deformed "ball", of one of a set of electrical conductors that lead through the openings away from the interconnection system. An insulating coating of a packaging material covers the body, the interconnection system, and the bonding portions in such a manner that only a part of each conductor protrudes through the coating.

A further layer lies on the insulating layer under the package coating but does not extend over the bonding portions. The further layer consists of an insulating material, preferably a transparent polymer, that has a glass transition temperature T_{G} below 150°C. T_{G} is preferably 25°C or less. The further layer is therefore elastomeric over a temperature range starting at a temperature below 150°C and extending above 150°C until decomposition occurs.

We believe that a significant portion of the volumetric expansion/contraction that causes stress in the device during thermal cycling between 150°C and a lower temperature (e.g., -65°C as in industry-standard life tests) normally occurs near 150°C. Consequently, the further layer alleviates stress across a portion of the temperature cycling range where stress-relief is needed most. If, as we also believe, significant stress is developed during excursions to low temperatures, reducing T_{G} provides more stress-relief.

In the method of fabricating the present device the patternable layer consists of actinic material.

Selected portions of the patternable layer are removed down to the pads. The removal step usually involves exposing portions of the patternable layer to radiation that causes the exposed portions to change their chemical structure and then developing the patternable layer to remove the selected portions. In any case, the remainder of the patternable layer forms the stress-relief layer. Next, the structure is provided with the electrical conductors that lead from the pads through the openings away from the interconnection system. The device is completed by covering the body, the interconnection system, and the layers with the package coating.

Alternatively, the patternable layer can be formed on the insulating layer before the openings are etched through it. In this case, selected portions of the patternable layer above the bond pads are removed after which underlying portions of the insulating layer are removed to expose the pads. The device is then finished in the way specified above. While the alternative method saves a masking step, it is more difficult to implement effectively if the material of the stress-relief layer is not well suited for use as an etching mask.

The invention will now be described, more fully by way of example, with reference to a drawing. In this drawing:
Figures 1a, 1b, 1c, 1d, 1e, and 1f are cross-sectional structural views illustrating steps in a prior art IC manufacturing process. Figures 1a - 1c show part of a full wafer, while Figures 1d - 1f specialize to one of the dies.
Figures 2a, 2b, 2c, 2d, 2e, and 2f are cross-sectional structural views illustrating steps in an IC manufacturing process according to the invention starting from the structure of Figure 1c. Figures 2a - 2c show part of a full wafer. Figures 2d - 2f specialize to one of the dice of the invention.
Figure 3a, 3b, and 3c are cross-sectional structural views illustrating alternative steps leading from the structure of Figure 1a to the structure of Figure 2c according to the invention.

Like reference symbols are employed in the drawings and in the description of the preferred embodiments to represent the same or very similar item or items.

The following convention is employed for actinic material in the drawings. During and after exposure to suitable actinic radiation, crossed shading denotes actinic material that remains after development. During exposure, dotted shading represents actinic material that is removed during development. Because the drawings illustrate actinic material of negative tone, dotted shading is used for actinic material prior to exposure.

The light parts of the radiation masks shown in the drawings are the areas through which actinic radiation can pass. The dark parts of the radiation masks are the areas that block actinic radiation.

The microelectronic components in a semiconductor device such as an integrated circuit (IC) or a discrete device can easily be damaged by forces in the harsh external world. Some sort of packaging material is normally placed around the electronic components to protect them from the outside environment. The packaging material must, however, be situated on the device in such a way that the material does not in itself cause the components to fail.

Some of the problems that arise in placement of the packaging material can be understood with reference to Figures 1a - 1f which illustrate the final stages in the fabrication, including the packaging, of a group of conventional IC's. The starting point for making the IC's is a semiconductor wafer containing a number of dies.

At the stage indicated in Figure 1a, the wafer consists of a monocrystaline silicon semiconductive substrate 10, a group of electrical interconnection systems 12, one for each die, and an electrically insulating layer 14 of a passivating material such as phosphosilicate glass or silicon nitride. Various N-type and P-type regions (not shown in the drawings) exist in substrate 10. Each interconnection system 12 consists of a set of electrical lines and insulators formed on substrate 10. The lines are selectively connected to the N-type and P-type regions. Items 16 in systems 12 are the metallic bond pads, typically consisting of an aluminum alloy, through which the dies electrically communicate with the outside world. Insulating layer 14 overlies systems 12 and extends down to substrate 10 at the intended locations 18 for the side boundaries of the portions of substrate 10 used in the various IC's. More particularly, locations 18 which laterally circumscribe each system 12, are the places where the wafer is later cut into separate dies.

Before going further, a comment needs to be made about lithographic terminology. Material is "actinic" if it can be formed into a lithographic pattern by selectively exposing portions of a layer of the material to radiation that causes the exposed portions to change their chemical structure and subsequently developing the layer to remove either the exposed portions or the unexposed portions. Actinic material such as photoresist is negative "tone" when the exposed portions (of changed chemical structure) remain after development. The "tone" is positive if the unexposed portions remain after development.

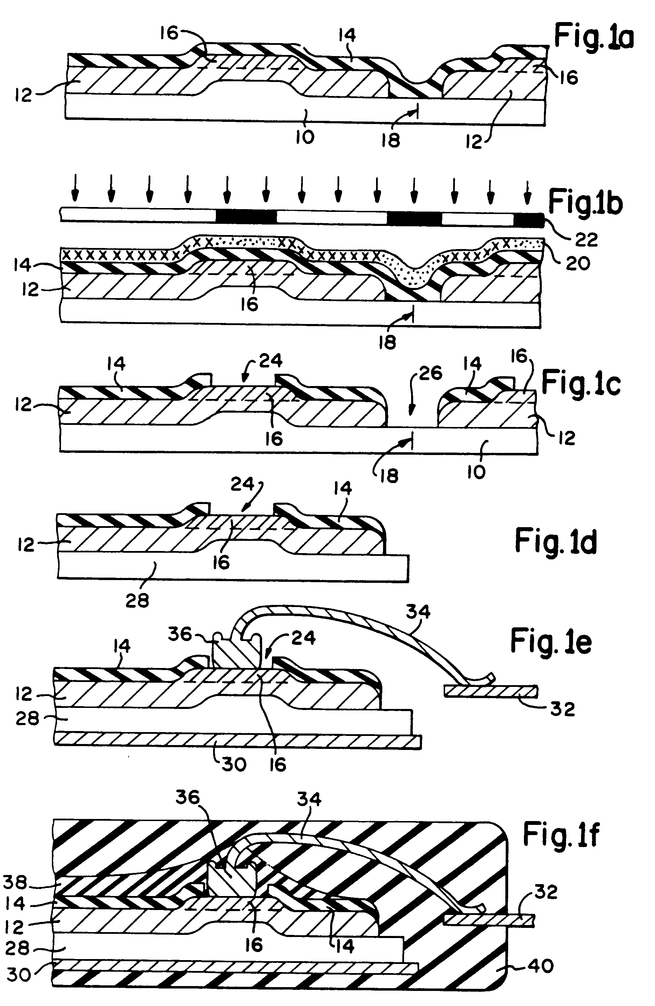

Turning back to Figures 1a - 1f, a blanket masking layer 20 of photoresist is formed on layer 14 as shown in Figure 1b. Photoresist layer 20 is selectively exposed to ultraviolet (UV) light through a radiation mask 22. If, for example, the tone of the photoresist is negative, mask 22 has opaque areas that prevent UV light from impinging on parts of layer 20 lying above bond pads 16 and locations 18. After developing layer 20 to remove the unexposed photoresist, layer 14 is etched through the resulting apertures in layer 20 to form bond pad openings 24 and scribe line openings 26 that respectively extend down to pads 16 and locations 18. The remaining photoresist is removed to produce the structure depicted in Figure 1c.

Next, substrate 10 is scribed along locations 18 to break the wafer into the separate dies, one for each IC. Figure 1d illustrates one of the resulting dies. The portion of substrate 10 used in the die of Figure 1d is indicated as semiconductive body 28.

Concentrating on this particular die, body 28 is mounted on the central section 30 of a metallic lead frame having a set of leads 32 separate from section 30. See Figure 1e. Leads 30 are connected respectively to pads 16 by way of gold wires 34. The combination of leads 32 and wires 34 forms a set of electrical conductors that connect system 12 with the external world. At the place where each wire 34 is bonded to its pad 16 in its opening 24, wire 34 spreads out into a deformed "ball" 36.

The die can now be packaged in various ways. In one packaging technique investigated in the prior art, a small amount of a liquid such as a silicone is deposited on top of the die and then suitably treated to form an electrically insulating elastomeric (or rubbery) layer 38. See Figure 1f. Portions of elastomeric layer 38 normally "wick up" slightly over balls 36. The resulting structure is encapsulated with a package coating 40 of a hard electrically insulating material in such a way that only a part of each lead 32 protrudes through coating 40.

Coating 40 typically consists of an epoxy or other thermosetting resin molded around the die and lead frame at an elevated temperature. During the subsequent cooldown to room temperature, coating 40 shrinks much more than the die and lead frame. Layer 38 relieves much of the severe mechanical stress that would otherwise be placed on body 28 and interconnection system 12 as a result of the cooldown shrinkage.

The IC is now subjected to accelerated life tests to assess how it will perform. The tests typically entail cycling the IC rapidly between the industry-standard limits of -65°C and 150°C in both an air environment and a liquid environment.

A major difficulty with the IC of Figure 1f centers around the part of each wire 34 where the top of layer 38 adjoins coating 40 just above associated ball 36. During the life tests, this part of wire 34 often breaks after a small number of thermal cycles, resulting in IC failure. The breakage mechanism appears to be fatigue produced by large differential thermal expansions/contractions in the IC that cause the portions of wire 34 in coating 40 to be shifted back and for the relative to the portion of wire 34 in layer 38.

Eliminating stress-relief layer 38 shifts the area of high stress down to balls 36. Because the area of each ball 36 where it contacts its pad 16 is much greater, typically at least four times greater, than the cross-sectional area of the remainder of its wire 34, ball 36 rarely breaks if layer 38 is absent. At the worst, ball 36 moves slightly. This is usually not catastrophic since ball 36 normally remains in contact with pad 16. However, the electronic components in interconnection system 28 and substrate 12 are now subjected to high stress during the thermal cycling and can fail unduly rapidly. It would be desirable to have a mechanism that avoids placing substantial stress on system 28 and substrate 12 without causing wires 43 to break.

The present invention centers on a particular use of stress-relief material having certain elastomeric characteristics. The temperature at which a material changes from a flexible, elastomeric state to a brittle, glassy state is termed the glass transition temperature. The material is glassy below the glass transition temperature. Above it, the material is elastomeric until the temperature goes so high that the material decomposes. Although the transition from an elastomeric phase to a glassy phase occurs over a temperature range, a material can normally be assigned a relatively precise glass transition temperature by utilizing appropriate extrapolation techniques. For more details, see Rosen, Fundamental Principles of Polymeric Materials (John Wiley & Sons: 1982), chap. 8, pp. 88 et seq.

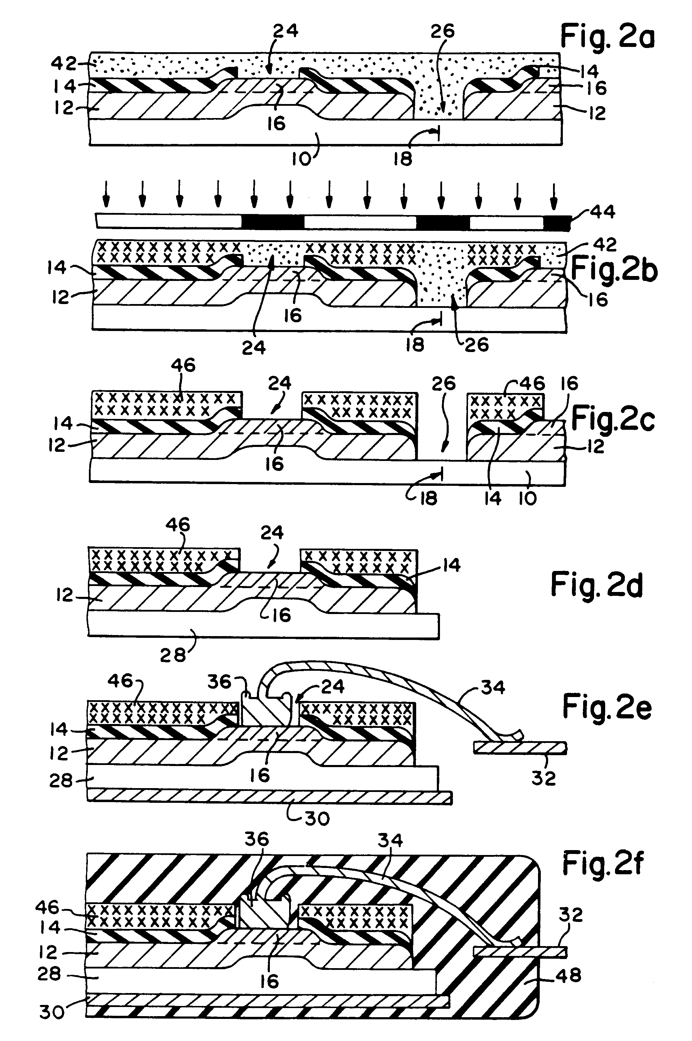

Referring to the drawings, Figures 2a - 2f illustrate stages in a preferred method for completing the fabrication of a group of packaged IC's having stress-relief in accordance with the invention. The starting point for Figures 2a - 2f is Figure 1c in which the wafer has been processed through the selective etching of insulating layer 14 to form bond pad openings 24 and scribe line openings 26. The thickness of layer 14 is preferably 0.7 µm if it consists of silicon nitride or 1 µm if it consists of phosphosilicate glass. Openings 24 are generally square about 125 µm along a side. Openings 26 are grooves having a width of about 100 µm.

A patternable blanket layer 42 of an electrically insulating actinic material is formed on layer 14 and in openings 24 and 26 down to pads 16 and substrate 10 as depicted in Figure 2a. The actinic material is of such a nature that, after further processing, the remainder of layer 42 has the stress-relief characteristics given below. Also, layer 42 is preferably transparent and remains so after further processing. This facilitates subsequent inspection of the wafer and the resulting dies.

Layer 42 is now selectively exposed to appropriate actinic radiation through a radiation mask 44 as depicted in Figure 2b. The radiation can take various forms such as UV light, X rays, and electrons depending on the characteristics of the actinic material. The material in layer 42 is, for example, negative tone. In this case, mask 44 has blocking areas that prevent the radiation from impinging on the portions of layer 42 lying on pads 16 and on substrate 10 at intended side boundary locations 18.

Utilizing a suitable developer, layer 42 is developed to remove the unexposed portions down to pads 16 and substrate 10 at locations 18. Items 46 in Figure 2c are the electrically insulating portions of layer 42 remaining after exposure and development. Portions 46 generally overlie (the remainder of) layer 14 but largely do not extend into openings 24 and 26.

The thermal expansion coefficient α_{RES} of the thermosetting resin later used to package each die normally increases slowly with increasing temperature until a temperature T_{C} slightly under 150°C is reached at which α_{RES} starts to increase sharply. T_{C} is typically about 130°C. The thermal expansion coefficients, collectively referred to as α_{OTH} here, for the other relevant IC components usually increase slowly with temperature up through 150°C. Below T_{C}, α_{RES} is considerably greater than α_{OTH}. However, as the temperature rises above T_{C}, α_{RES} rapidly becomes very much greater than α_{OTH}. It thus appears that a large part of the mechanical stress produced in the finished IC's during standard thermal cycling life tests between -65°C and 150°C is caused by the differential volumetric expansion/contractions that occur during the transitions between T_{C} and 150°c. Accordingly, the glass transition temperature of the material in portions 46 is below 150°C so as to relieve stress in the IC's.

The amount of stress-relief appears to increase as T_{G} decreases. If T_{G} is less than T_{C}, a substantial amount of stress is alleviated since portions 46 are elastomeric over the T_{C}-to-150°C portion of the standard thermal cycling range (as well as the T_{G}-to-T_{C} portion). For IC's used in room-temperature applications, this is safely achieved by arranging for T_{G} to be 25°C or less. A value of 25°C or less for T_{G} assures that portions 46 are rubbery over the entire temperature range that such IC's experience during operation.

Largely the maximum amount of stress-relief is achieved during the standard thermal life tests if T_{G} is -65°C or lower. Such a T_{G} value is desirable for IC's used in very cold environments.

The maximum temperature that the dies experience during the subsequent processing steps described below is normally 275°C-300°C. The temperature during normal IC operation rarely, if ever, goes above this. Consequently, portions 46 should not significantly decompose at or below 300°C.

In the preferred embodiment, the material of layer 42 in Figure 2b is a photosensitive negative-tone transparent viscous room-temperature liquid of the type described in U.S. Patent 4,279,717. The liquid is a combination of experimental materials GE 479-1866 and GE 479-1350C supplied by General Electric Co. The proportions are preferably 90 parts by weight of GE 479-1866 to 10 parts by weight of GE 479-1350C. Exposure to UV light converts the liquid into a silicone polymer.

Layer 42 is formed to an average thickness of 3 - 5 µm by depositing a specified amount of the liquid on the upper surface of the structure of Figure 1c and then spinning the resultant structure to produce a relatively flat upper surface. No bake step is required. The selective exposure of layer 42 is performed with UV light at a dosage ranging from 0.2 to 2 joules/cm². The development of layer 42 is done with n-hexane for 20 to 60 seconds.

T_{G} for the resulting material of portions 46 in Figure 2c is about -100°C. Decomposition does not begin until the temperature is 350°C - 400°C.

In the present example, layer 42 and photoresist layer 20 used in forming openings 24 and 26 (as shown in Figure 1b) are of the same tone -- negative in this case. Since portions 46 are generally in vertical alignment with the remaining portions of insulator 14, the areas of mask 44 through which the actinic radiation passes are located in the same respective places as the areas of mask 22 through which the UV light passes. If the material that forms the radiation-blocking pattern in mask 44 is (or can be) the same as the material that blocks UV light in mask 22, masks 44 and 22 can be the same or substantially identical radiation masks. This is also true if both of layers 42 and 20 are positive tone. The only difference is that the locations of the blocking and transmitting mask areas are reversed from those indicated in Figures 1b and 2b.

Due to the inherent error in aligning mask 44 and 22 to the wafer, parts of layers 46 normally occupy small sections of openings 24 and 26 along their side edges. (This is not illustrated in the drawings.) Should the partial filling of openings 24 and 26 with material of portions 46 be intolerable, the radiation-blocking areas in mask 44 can be made slightly larger than those in mask 22 if the material in layer 42 is negative tone. The reverse applies if the tone of the material in layer 42 is positive.

Layers 42 and 20 may be of opposite tone. Masks 44 and 22 then must invariably be different.

Returning to the general processing sequence, the wafer is broken into separate dies in the way described above for Figure 1d. One of the resulting die is shown in Figure 2d. Portion 46 for this die is a continuous layer perforated by openings that merge into openings 24. The portions of substrate 10 used in the die of Figure 2d is again indicated as body 28.

Likewise, the die is provided with a metallic lead frame and intermediate wires 34 in the manner described for Figure 1e. The process of attaching the die to the lead frame may be done at a temperature as high as 280°C. The wire diameter is preferably 25 - 35 µm. As indicated in Figure 2e, the tops of balls 36 normally extend above the top of layer 46.

The IC is now packaged conventionally. The die, lead frame, and composite conductors 32 and 34 are encapsulated in a hard electrically insulating coating 48 such that only parts of leads 32 protrude through coating 48. See Figure 2f. package coating 48 consists, for example, of a thermosetting resin such as epoxy cresol novolac hardened with phenol formaldehyde novolac. T_{C} for this resin is about 130°C.

Layer 46 prevents damage to the electronic components in the IC by substantially alleviating the above-described mechanical stress that would otherwise act on body 28 and interconnection system 12 as a result of the packaging cooldown shrinkage and subsequent thermal cycling. Coating 48 holds the entire length of each wire 34 firmly in place down to its ball 36. Consequently, the amount of thermal fatigue experienced by wire 34 down to ball 36 is greatly lessened so as to markedly reduce the likelihood of wire breakage. The highest thermally produced stress occurs at the bases of balls 36 which, for the reasons given above, normally can tolerate the stress.

An important advantage of the present packaging technique is that the stress-relief material is simultaneously applied to many dies on a wafer. This is more economical than the above-mentioned prior art technique in which stress-relief layer 38 is formed separately on each die.

Turning to Figures 3a - 3c, they illustrate the critical features in another method for producing stress-relief layers 46. In this alternative, portions 46 are employed as a mask in etching layer 14. The starting point for Figures 3a - 3c is Figure 1a in which the wafer has been processed up through the formation of insulator 14 on interconnection systems 12. A blanket patternable layer 58 of an electrically insulating actinic material is formed on layer 14 as shown in Figure 3a. The material of layer 58 has all the characteristics given above for the material of layer 42.

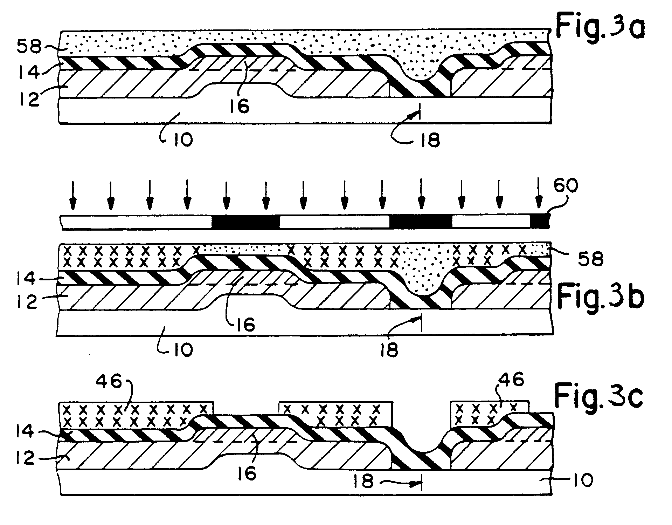

Layer 58 is selectively exposed to actinic radiation through a radiation mask 60 as shown in Figure 3b. If the actinic material is negative tone, mask 60 has blocking areas that prevent the radiation from impinging on portions of layer 58 lying above pad 16 and body 10 at locations 18. The reverse applied if the actinic material is positive tone.

For either tone, a suitable developer is employed to remove portions of layer 58 down to parts of insulator 14 laying on pad 16 and on body 10 at locations 18. See Figure 3c. Portions 46 are the parts of layer 58 remaining after exposure and development. Layer 14 is then etched through the openings in and between portions 46, thereby again achieving the structure of Figure 2c. The steps of Figures 2d - 2f are subsequently followed to complete IC fabrication.

The instant stress-relief layer can also be employed in discrete semiconductor devices. The package coating need not fully encapsulate the semiconductive body, interconnection system, overlying insulating layer, and stress-relief layer as long as it covers them on the top side. It might thus be possible to use the present stress-relief layer in a hybrid circuit.

## Claims

1. A method of fabricating a semiconductor device in which an electrically insulating layer (14) lies on an electrical interconnection system (12) contacting a semi-conductor body (10), openings (24) extend through the insulating layer down to bond pads (16) of the interconnection system (12), each pad is in contact with a bonding portion (36) of a different one of a set of electrical conductors (32, 34) that lead through the openings (24) away from the interconnection structure, and an electrically insulating coating (48) covers the body (10), the interconnection system (12), the insulating layer (14), and the bonding portions (36) such that a part (32) of each conductor (32,34) protrudes through the coating (48), in which method a stress-relief layer (46), which lies above the interconnection system (12) but does not lie above areas of the bond pads (16), where the bonding portions (36) are made, is formed between the insulating layer (14) and the insulating coating (48), wherein the stress-relief layer is made by forming a patternable layer (42, 58) on the insulating layer (14) and exposing portions of the patternable layer to radiation that causes the so exposed portions to change their chemical structure; and developing the patternable layer to remove parts of the patternable layer down to the pads (16), characterised in that the remainder of the patternable layer, which forms the stress-relief layer (46), consists substantially of a polymeric, electrically insulating material that has a glass transition temperature T_{G} below 150°C.

2. A method as in Claim 1 characterized in that T_{G} is -65°C or less.

3. A method as in Claim 1 or 2, characterized in that the remainder of the patternable layer (46) is used to etch the insulating layer (14) so as to form the openings (24) to the bond pads (16).

## Patentansprüche

1. Verfahren zum Herstellen einer Halbleiteranordnung, in der eine elektrisch isolierende Schicht (14) auf einem elektrischen Verbindungssystem (12) in Kontakt mit einem Halbleiterkörper (10) steht, wobei Öffnungen (24) sich durch die Isolierschicht hinunter auf Kontaktgebieten (16) des Verbindungssystems (12) erstrecken, jedes Kontaktgebiet mit einem Kontaktanteil (36) eines anderen Leiters einer Gruppe elektrischer Leiter (32, 34) in Kontakt steht, die durch die Öffnungen (24) weg von der Verbindungsstruktur führen, und eine elektrische Isolierbeschichtung (48) den Körper (10), das Verbindungssystem (12), die Isolierschicht (14) und die Kontaktanteile (36) derart bedeckt, daß ein Teil (32) jedes Leiters (32, 34) aus der Beschichtung (48) herausragt, wobei mit diesem Verfahren eine Spannungsentlastungsschicht (46), die über dem Verbindungssystem (12), aber nicht über Bereichen der Kontaktgebiete (16) liegt, in denen die Kontaktanteile (36) gemacht werden, zwischen der Isolierschicht (14) und der Isolierbeschichtung (48) gebildet wird, worin die Spannungsentlastungsschicht durch das Anbringen einer bemusterbaren Schicht (42, 58) auf der Isolierschicht (14) hergestellt wird und Anteile der bemusterbaren Schicht mit Strahlung belichtet werden, die die so belichteten Anteile zum Ändern ihrer chemischen Struktur veranläßt, und die bemusterbare Schicht zum Entfernen von Teilen der bemusterbaren Schicht hinunter auf das Kontaktgebiet (16) entwickelt wird, dadurch gekennzeichnet, daß der Rest der bemusterbaren Schicht, die die Spannungsentlastungsschicht (46) bildet, im wesentlichen aus einem polymeren elektrisch isolierenden Material besteht, das eine Glasübergangstemperatur T_{G} unter 150°C hat.

2. Verfahren nach Anspruch 1, dadurch gekennzeichnet, daß T_{G}-65°C oder weniger ist.

3. Verfahren nach Anspruch 1 oder 2, dadurch gekennzeichnet, daß der Rest der bemusterbaren Schicht (46) zum Ätzen der Isolierschicht (14) verwendet wird, um die Öffnungen (24) nach den Verbindungsstreifen (16) zu bilden.

## Revendications

1. Procédé pour la fabrication d'un dispositif semiconducteur, selon lequel une couche électriquement isolante (14) se situe sur un système d'interconnexion électrique (12) qui est en contact avec un corps semiconducteur (10), des ouvertures (24) s'étendent à travers la couche isolante jusqu'aux plages de soudure (16) du système d'interconnexion (12), chaque plage est en contact avec une partie de soudure (36) d'un conducteur électrique d'un jeu de conducteurs électriques (32, 34) qui s'étendent à travers les ouvertures (24) à partir de la structure d'interconnexion, et un recouvrement électriquement isolant (48) recouvre le corps (10), le système d'interconnexion (12), la couche isolante (14) et les parties de soudure (36) de façon qu'une partie (32) de chaque conducteur (32, 34) sorte du recouvrement (48), procédé selon lequel une couche réduisant la contrainte (46) qui se situe au-dessus du système d'interconnexion (12) mais qui ne se situe pas au-dessus des régions des plages de soudure (16) où sont réalisées les parties de soudure (36) est formée entre la couche isolante (14) et le recouvrement isolant (48), selon lequel la couche réduisant la contrainte est réalisée par formation d'une couche à configurer (42, 58) sur la couche isolante (14) et exposition de parties de la couche à configurer à du rayonnement provoquant une variation de la structure chimique des parties ainsi exposées et développement de la couche à configurer afin d'enlever des parties de la couche à configurer jusqu'aux plages (16), caractérisé en ce que le reste de la couche à configurer, qui constitue la couche réduisant la contrainte (46), est essentiellement constitué par un matériau électriquement isolant polymère présentant une température de transition de verte T_{G} inférieure à 150°C.

2. Procédé selon la revendication 1, caractérisé en ce que T_{G} est de -65°C ou moins.

3. Procédé selon la revendication 1 ou 2, caractérisé en ce que le reste de la couche à configurer (46) est utilisé pour décaper la couche isolante (14) de façon à former les ouvertures (24) jusqu'aux plages de soudure (16).
